# EUROPEAN PATENT APPLICATION

(11) **EP 2 284 907 A1**
(43) Date of publication of application: **16.02.2011**
(21) Application number: 09754504.0
(22) Date of filing: 23.03.2009
(51) Int. Cl.: H01L 31/04

(54) **SOLAR BATTERY, METHOD FOR MANUFACTURING SOLAR BATTERY, AND SOLAR BATTERY MODULE**

(30) Priority: 30.05.2008 JP 2008143126
(71) Applicant: Sharp Kabushiki Kaisha, Osaka-shi, Osaka 545-8522 (JP)
(72) Inventor: FUNAKOSHI, Yashshi, Osaka-shi, Osaka 545-8522 (JP)
(74) Representative: Müller - Hoffmann & Partner
(86) International application number: PCT/JP2009/055620
(87) International publication number: WO 2009/144996

(57) **Abstract**

There is provided a solar battery, including: a solar cell including an electrode (7, 7a, 8, 8a) having a contact resistance with a silicon substrate (1) of 70 mΩ•cm² or less; and a conductive member for electrically connecting to the electrode (7, 7a, 8, 8a) of the solar cell, the solar cell being arranged on the conductive member such that the electrode (7, 7a, 8, 8a) of the solar cell is electrically connected to the conductive member. There is also provided a method for manufacturing the solar battery and a solar cell module using the solar battery.

## Description

### TECHNICAL FIELD

The present invention relates to a solar battery, a method for manufacturing the solar battery and a solar cell module. Particularly, the present invention relates to a solar battery capable of suppressing the resistance of an electrode to be low and enhancing properties, a method for manufacturing the solar battery and a solar cell module.

### BACKGROUND ART

In recent years, development of a clean energy source has been desired because of global environmental problems and the like such as exhaustion of energy resources and an increase in CO₂ in the atmosphere. In particular, the photovoltaic power generation using a solar cell has been developed, put to practical use and is progressing as a new energy source.

A solar cell obtained by diffusing, into a light receiving surface of a monocrystalline or polycrystalline silicon substrate having one conductivity type, impurities having a conductivity type opposite to the conductivity type of the silicon substrate to form a p-n junction and forming electrodes on the light receiving surface and a back surface of the silicon substrate, respectively, has been conventionally the mainstream. In addition, a solar cell obtained by forming, on a back surface of a silicon substrate having one conductivity type, an impurity layer including a high concentration of impurities having the same conductivity type as the conductivity type of the silicon substrate to increase the output due to the back surface field effect has also been common.

Furthermore, a back electrode type solar cell obtained by forming a p electrode and an n electrode on a back surface of a silicon substrate without forming an electrode on a light receiving surface of the silicon substrate has also been developed (see Patent Document 1 (Japanese National Patent Publication No. 2006-523025)). In the back electrode type solar cell, the electrode is not generally provided on the light receiving surface, and thus, the shadow loss is not produced by the electrode and high output is expected as compared with the solar cell having the electrodes on the light receiving surface and the back surface of the silicon substrate, respectively.
Patent Document 1: Japanese National Patent Publication No. 2006-523025

### DISCLOSURE OF THE INVENTION

### PROBLEMS TO BE SOLVED BY THE INVENTION

In order to obtain high conversion efficiency in a solar cell, it is important to keep the carrier lifetime high, and to that end, manufacturing the solar cell at a low treatment temperature is effective. In particular, the treatment temperature during formation of an electrode of the solar cell significantly affects the carrier lifetime. Therefore, by decreasing this treatment temperature, high conversion efficiency can be expected.

In reality, however, the decrease in treatment temperature during formation of the electrode of the solar cell has caused high contact resistance between a silicon substrate and the electrode or high resistivity of the electrode itself, and thus, obtainment of the expected results has been impossible.

In particular, the electrode commonly used in the solar cell and formed by firing includes metallic powder as a main ingredient. Therefore, when the treatment temperature during formation of the electrode is decreased, the metallic powder does not sufficiently adhere to each other. Furthermore, since a glass frit is added to improve contact with the silicon substrate, the resistivity of the electrode itself becomes high. On the other hand, when the glass frit is not added to lower the resistivity of the electrode itself, the contact resistance with the silicon substrate becomes very high. Therefore, it has been very difficult to decrease both a value of the resistivity of the electrode itself and a value of the contact resistance in the low-temperature treatment.

In addition, in the back electrode type solar cell as described in Patent Document 1, there are a p+ layer, an n+ layer, the p electrode, and the n electrode on the back surface of the back electrode type solar cell, respectively. Therefore, the structure is complicated, and bus bar electrodes for the p electrode and the n electrode must be provided at opposing ends on the back surface in order to serially connect to an adjacent back electrode type solar cell when a solar cell module is manufactured. Thus, the length of a finger electrode must be nearly equal to the width of the silicon substrate. As a result, the large amount of current tends to flow through one finger electrode and the resistance loss at the finger electrode tends to be produced. For this reason, in the back electrode type solar cell, the resistance of the electrode has needed to be suppressed to be lower than that of the common solar cell having the electrodes on the light receiving surface and the back surface of the silicon substrate, respectively.

In view of the above circumstances, an object of the present invention is to provide a solar battery capable of suppressing an influence of the resistance of an electrode to be low even when the resistance of the electrode is high and enhancing properties, a method for manufacturing the solar battery and a solar cell module.

### MEANS FOR SOLVING THE PROBLEMS

The present invention is directed to a solar battery, including: a solar cell including an electrode having a contact resistance with a silicon substrate of 70 mΩ•cm² or less; and a conductive member for electrically connecting to the electrode of the solar cell, the solar cell being arranged on the conductive member such that the electrode of the solar cell is electrically connected to the conductive member.

In the solar battery of the present invention, the electrode preferably includes Ag, Ni, Cu, or A1 as a main ingredient.

In addition, in the solar battery of the present invention, the electrode preferably has a thickness of 20 µm or less.

In addition, in the solar battery of the present invention, a pattern of formation of the electrode preferably substantially overlies a pattern of formation of the conductive member when the pattern of formation of the electrode is electrically connected to the pattern of formation of the conductive member.

In addition, in the solar battery of the present invention, the conductive member is preferably a wiring substrate including an insulating base material and a wiring placed on the insulating base material.

In addition, in the solar battery of the present invention, the wiring preferably includes Ag, Ni, Cu, or Al as a main ingredient.

In addition, in the solar battery of the present invention, a width of the electrode is preferably smaller than a width of the wiring of the wiring substrate.

In addition, in the solar battery of the present invention, in the solar cell, a p electrode and an n electrode are both preferably formed on a back surface side of the silicon substrate. In addition, in the solar battery of the present invention, the electrode is preferably a fired electrode.

In addition, the present invention is directed to a method for manufacturing any of the above solar batteries, the electrode being formed by printing an electrode paste including metallic powder as a main ingredient, and then, firing the electrode paste.

In addition, in the method for manufacturing the solar battery of the present invention, the electrode paste preferably contains the metallic powder, a solvent, a thickener, and a glass frit having a softening point of 450°C or less.

In addition, in the method for manufacturing the solar battery of the present invention, the electrode paste is preferably fired at a temperature of 550°C or less.

In addition, the present invention is directed to a method for manufacturing any of the above solar batteries, the electrode being formed by electrolytic plating, electroless plating or vacuum deposition.

Furthermore, the present invention is directed to a solar cell module, formed by sealing any of the above solar batteries with a sealant.

### EFFECTS OF THE INVENTION

According to the present invention, there can be provided a solar battery capable of suppressing the resistance of an electrode to be low and enhancing properties, a method for manufacturing the solar battery and a solar cell module.

### BRIEF DESCRIPTION OF THE DRAWINGS

Fig. 1 (a) to (e) are schematic cross-sectional views illustrating one example of a method for manufacturing a solar cell module of the present invention.
Fig. 2 (a) to (c) are schematic plan views illustrating one example of a pattern of an electrode of a solar cell used in the present invention.
Fig. 3 is a schematic plan view of one example of a wiring substrate used in the present invention.
Fig. 4 is a schematic cross-sectional view of one example of a solar battery of the present invention.
Fig. 5 illustrates the correlation between the contact resistance of the electrode and the F.F. of the solar cell used in the present invention.
Fig. 6 (a) to (e) are schematic cross-sectional views illustrating another example of the method for manufacturing a solar cell module of the present invention.
Fig. 7 (a) and (b) are schematic diagrams illustrating one example of a method for measuring properties of the solar cell, and Fig. 7 (a) is a schematic plan view before an interconnector is connected to the electrode of the solar cell, and Fig. 7 (b) is a schematic cross-sectional view after the interconnector is connected to the electrode of the solar cell.
Fig. 8 (a) to (c) are schematic diagrams illustrating one example of a method for measuring properties of the solar battery; Fig. 8 (a) is a schematic plan view of the solar cell before the wiring substrate is connected; Fig. 8 (b) is a schematic plan view of the wiring substrate before the wiring substrate is connected to the solar cell; and Fig. 8 (c) is a schematic cross-sectional view of the solar battery after the wiring substrate shown in Fig. 8 (b) is connected to the solar cell shown in Fig. 8 (a).

### DESCRIPTION OF THE REFERENCE SIGNS

1 silicon substrate; 2 antireflection film; 3 p+ layer; 4 n+ layer; 5 passivation film; 7, 7a p electrode; 8, 8a n electrode; 9 p wiring; 10 n wiring; 11 insulating base material; 12 translucent member; 13 translucent sealant; 14 weather-resistant base material; 15 terminal box; 16 frame; 17 slit; 18 connecting wiring; 19 interconnector

### BEST MODES FOR CARRYING OUT THE INVENTION

Embodiments of the present invention will be described hereinafter. In the drawings of the present invention, the same or corresponding components are denoted with the same reference characters.

### (First Embodiment)

One example of a method for manufacturing a solar cell module of the present invention will be described hereinafter with reference to schematic cross-sectional views in Figs; 1 (a) to (e).

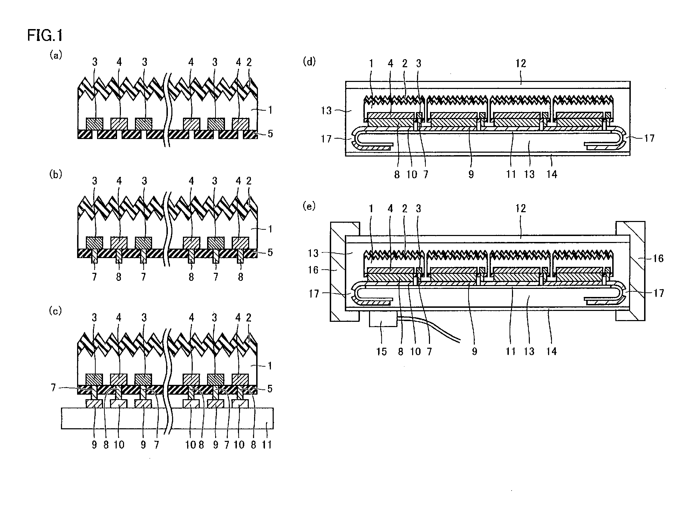

First, as shown in Fig. 1 (a), a p+ layer 3 formed by diffusing p-type impurities and an n+ layer 4 formed by diffusing n-type impurities are formed on a back surface of an n-type silicon substrate 1, for example. In addition, a passivation film 5 having a contact hole that is an opening formed to expose a part of a surface of p+ layer 3 and a part of a surface of n+ layer 4 is formed on the back surface of silicon substrate 1. Furthermore, an antireflection film 2 is formed on a light receiving surface of silicon substrate 1. Here, above antireflection film 2, p+ layer 3, n+ layer 4, and passivation film 5 can be formed by using a conventionally known method, respectively.

In addition, although each of p+ layer 3 and n+ layer 4 is alternately arranged in the shape of a line linearly extending from the front side to the rear side of the sheet of Fig. 1 in this example, p+ layer 3 and n+ layer 4 are not limited to this configuration.

Furthermore, the contact hole provided with passivation film 5 can be formed on each of p+ layer 3 and n+ layer 4 in the shape of, for example, a dot, a line or the like. The contact hole can be easily formed by, for example, printing a paste, which can etch passivation film 5, on passivation film 5 in the shape of the contact hole and heating the paste.

Next, as shown in Fig. 1 (b), an electrode paste is printed to fill the contact hole of passivation film 5 on the back surface of silicon substrate 1, and the electrode paste is fired. As a result, a p electrode 7 that is in contact with p+ layer 3 and an n electrode 8 that is in contact with n+ layer 4 are formed, respectively.

Here, the electrode paste preferably includes metallic powder of Ag, Ni, Cu, or Al as a main ingredient. It is noted that in the present invention, "main ingredient" refers to an ingredient that constitutes 50% or more by mass of the electrode paste. In addition, the above electrode paste preferably includes a solvent, a thickener and a glass frit having a softening point of 450°C or less, together with the above metallic powder.

Furthermore, the above electrode paste is preferably fired at a temperature of 550°C or less, and more preferably at a temperature of 450°C or less. The above electrode paste is fired at a temperature of 550°C or less, especially 450°C or less, so that a reduction in carrier lifetime in silicon substrate 1 can be suppressed and high solar battery properties can be expected.

In addition, the electrode paste includes the metallic powder of Ag, Ni, Cu, or Al as a main ingredient and the glass frit having a softening point of 450°C or less is used, so that an electrode (p electrode 7 and n electrode 8) that achieves excellent contact with silicon substrate 1 even in firing at a low temperature of 550°C or less can be obtained.

It is noted that the excellent contact means that the contact resistance is 70 mΩ•cm² or less, and preferably 50 mΩ•cm² or less. When this contact resistance is 70 mΩ•cm² or less, the fill factor (F.F.) of 0.7 or more can be expected. When the contact resistance is 50 mΩ•cm² or less, the F.F. of 0.75 or more can be expected (the detailed description will be provided below).

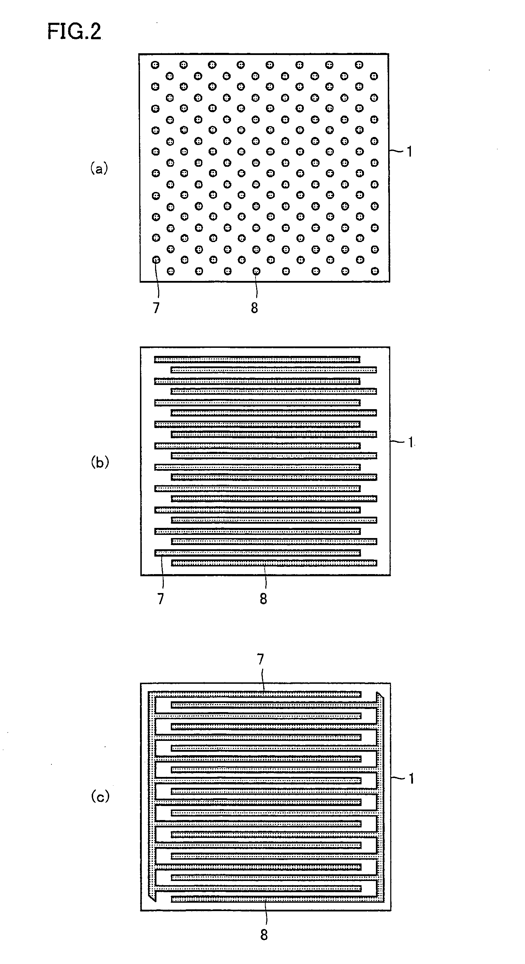

In addition, as for the shape of p electrode 7 and n electrode 8, p electrode 7 and n electrode 8 can be formed, for example, in the shape of a dot as shown in a schematic plan view in Fig. 2 (a), in the shape of a line as shown in Fig. 2(b), in the shape of a comb as shown in Fig. 2 (c), and the like.

It is noted that in the present invention, p electrode 7 and n electrode 8 may only achieve excellent contact with silicon substrate 1, and thus, increasing the cross-sectional area of the electrode to reduce the resistance of the electrode as in the prior art is not required. Therefore, the electrode paste is preferably printed to have enough width to cover the contact hole thinly. In this case, there is a tendency to allow reduction in amount of the expensive electrode paste used.

In addition, conventionally, printing the thick electrode paste has been required to increase the cross-sectional area of the electrode. Therefore, the electrode paste has been printed by screen printing, and other printing methods have not often been used.

In the present invention, however, the electrode paste may be printed thinly, and thus, printing by various printing methods such as ink-jet printing, offset printing, relief printing, and intaglio printing, in which thickening the film is difficult, is also possible in addition to screen printing. In other words, in the present invention, the electrode paste is printed using the method such as ink-jet printing that is excellent for printing of a thin line pattern as compared with screen printing, there is an increasing tendency to allow making the electrode thin and slim, and to allow reduction in amount of the electrode paste used.

Next, as shown in Fig. 1 (c), a solar cell is placed on a wiring substrate including a p wiring 9 and an n wiring 10 that correspond to p electrode 7 and n electrode 8 of the solar cell, respectively, such that p electrode 7 is placed on p wiring 9 and n electrode 8 is placed on n wiring 10. As a result, a solar battery of the present invention is fabricated.

Here, electrical connection between p electrode 7 and p wiring 9 as well as electrical connection between n electrode 8 and n wiring 10 may be achieved by, for example, a connection material such as solder or a conductive adhesive, or may be achieved only by physical press-bonding using vacuum press-bonding in a subsequent sealing step with a sealant without using this connection material. In addition, a pattern of formation of the electrode of the solar cell preferably substantially overlies a pattern of formation of the wiring of the wiring substrate when the pattern of formation of the electrode of the solar cell is electrically connected to the pattern of formation of the wiring of the wiring substrate.

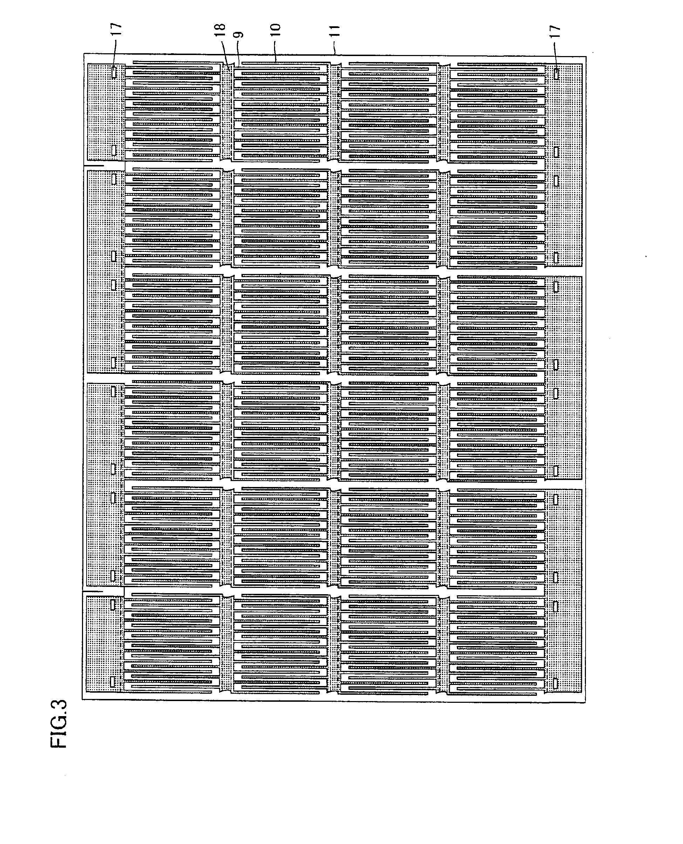

It is noted that a wiring substrate having a configuration shown in, for example, a schematic plan view in Fig. 3 can be used as the above wiring substrate. Here, a wiring substrate provided with the wiring including p wiring 9 and n wiring 10 on an insulating base material 11 can be used.

In addition, in the wiring of the wiring substrate, a slit 17 as shown in, for example, Fig. 3 may be formed, and a connecting wiring 18 that electrically connects p wiring 9 and n wiring 10 may be formed.

Furthermore, preferably, the wiring including p wiring 9 and n wiring 10 includes Ag, Ni, Cu, or Al as a main ingredient. Moreover, a flexible insulating base material including at least one type selected from the group consisting of polyethylene terephthalate, polyethylene naphthalate, polyimide, and ethylene vinyl acetate can, for example, be used as insulating base material 11.

Further, in the present invention, the electrode of the solar cell may only achieve excellent contact with the wiring of the wiring substrate, and thus, the electrode of the solar cell should be as small in surface area as possible in such a range that the properties of the solar battery are not affected, for the purpose of reducing the amount of the electrode paste used.

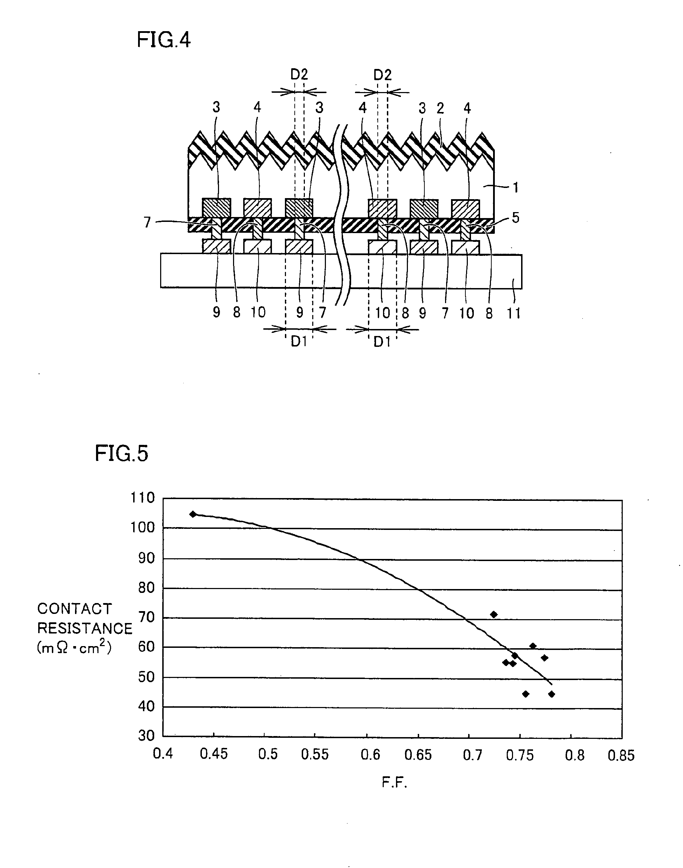

On the other hand, the wiring of the wiring substrate should be as large in surface area as possible for the purpose of sufficiently reducing the serial resistance to collect electricity collected from the solar cell. Accordingly, as shown in, for example, a schematic cross-sectional view in Fig. 4, a width D1 of the wiring of the wiring substrate is preferably larger than a width D2 of the electrode of the solar cell.

Next, as shown in Fig. 1 (d), the solar cell placed on the wiring substrate is sealed with a translucent sealant 13, a translucent member 12 such as glass, and a weather-resistant base material 14.

Finally, as shown in Fig. 1 (e), a terminal box 15 and a frame 16 are attached.

As a result, the solar cell module is completed. As described above, the solar cell module having an F.F. of 0.75 or more can be fabricated.

The relationship between the contact resistance of the electrode and the F.F. of the solar cell will be described hereinafter. First, several types of electrode pastes having slightly different compositions are prepared and a plurality of solar cells are fabricated under exactly the same conditions other than the electrode pastes.

Here, a difference among the electrode pastes manifests itself mainly as a difference in resistivity of the electrode of the solar cell and a difference in contact resistance between this electrode and the silicon substrate. Furthermore, the solar cell fabricated in such a manner is placed on the wiring substrate which has a sufficiently low wiring resistance and on which the wiring having the same shape as that of the electrode of the solar cell is formed, and the properties of the solar cell are evaluated. Since the resistance of the electrode of the solar cell is negligible, the correlation between the contact resistance of the electrode and the F.F. of the solar cell can be seen. Here, a value calculated using a TLM method is used as the contact resistance of the electrode of the solar cell with respect to the silicon substrate.

Fig. 5 illustrates the correlation between the contact resistance of the electrode and the F.F. of the solar cell. As shown in Fig. 5, when the contact resistance of the electrode of the solar cell is 70 mΩ•cm² or less, the F.F. of the solar cell tends to be 0.7 or more. When the contact resistance of the electrode of the solar cell is 50 mΩ•cm² or less, the F.F. tends to be 0.75 or more. Accordingly, this result shows that when the contact resistance of the electrode of the solar cell with respect to the silicon substrate is 70 mΩ·cm² or less, this electrode achieves excellent contact resistance with the silicon substrate.

In the present invention, the electrode paste is fired at a temperature of 550°C or less in order to maintain the carrier lifetime in the silicon substrate high. Therefore, the resistivity of the electrode of the solar cell becomes high, as compared with the case where the electrode paste is fired at a temperature of around 700°C as in the prior art. When the ingredients of the electrode paste other than the metallic powder are all organic, an electrode that shows sufficiently low resistivity is obtained by firing the electrode paste at a low temperature of 550°C or less. Excellent contact with the silicon substrate is not obtained, however.

The glass frit must be contained in the electrode paste in order to obtain excellent contact with the silicon substrate. Even when a glass frit having a low melting point is used in firing at a low temperature of 550°C or less, the glass frit does not sufficiently melt and contact between the metallic powder is blocked. Therefore, the resistivity of the electrode is considered to become high.

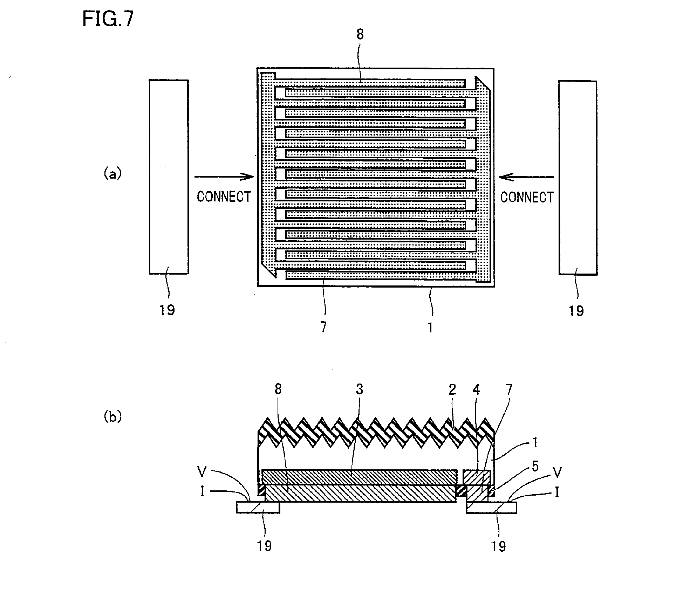

A comparison is made between the properties of the solar cell when the electrode is formed by firing at 450°C and the properties of the solar cell when the electrode is formed by firing at 650°C. Here, the wiring substrate is not used and only the electrode of the solar cell exists, and in this electrode, electricity is collected from the electrodes at opposing ends of the silicon substrate of the solar cell. As shown in Figs. 7 (a) and (b), an interconnector 19 is connected to a collector electrode of each of p electrode 7 and n electrode 8 (portions of p electrode 7 and n electrode 8 extending in the vertical direction in Fig. 7 (a)) and the properties of the solar cell are measured using a four-terminal method. At this time, the contact resistance of the electrode with respect to the silicon substrate is confirmed to be 50 mΩ•cm² or less at both firing temperatures of 450°C and 650°C. In addition, the pattern of the electrode of the solar cell is the same, and in order to reduce the resistance of the electrode as much as possible, a spacing between p electrode 7 and n electrode 8 is minimized in such an extent that p electrode 7 does not contact n electrode 8. As a result, the electrode is formed to have a large width of about 300 µm and a thickness of 20 µm, which is the largest possible thickness that can be achieved by screen printing. The back surface of this solar cell has an area of 105 cm², a finger electrode (portions of p electrode 7 and n electrode 8 extending in the horizontal direction in Fig. 7 (a)) is formed with a 1 mm pitch, and the finger electrode has a length of 10 cm. In addition, the contact hole has a shape of a line, and has a width of 100 µm and a length of 10 cm. The short circuit current density (Jsc) of the solar cell at this time is about 37 mA/cm².

Table 1 shows the properties of a single solar cell and the resistivity of the electrode.

**[Table 1]**

| Firing Temperature | Short Circuit Current Density Jsc (mA/cm²) | Open-circuit Voltage Voc (V) | F.F. | Conversion Efficiency Eff (%) | Resistivity p of Electrode (Ω•cm) |
|---|---|---|---|---|---|
| 650°C | 36.49 | 0.640 | 0.763 | 17.82 | 8.7 × 10⁻⁶ |
| 450°C | 37.26 | 0.646 | 0.726 | 17.46 | 1.7 × 10⁻⁵ |

As shown in Table 1, resistivity p of the electrode when the electrode paste is fired at 650°C is about twice as high as resistivity p of the electrode when the electrode paste is fired at 450°C. This difference accounts for a difference in F.F.

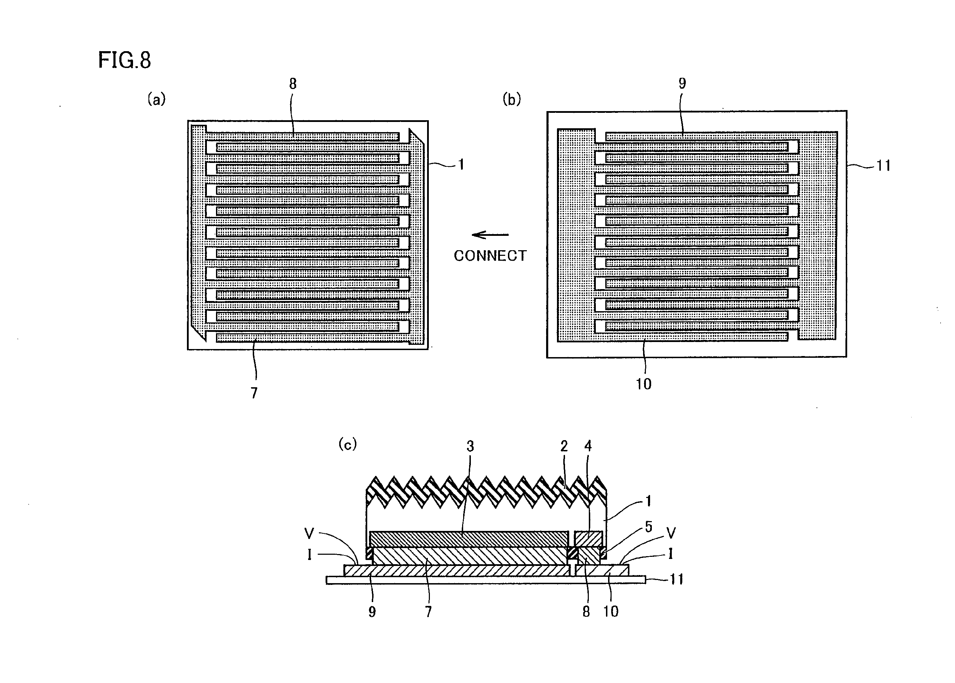

In addition, the solar cell fabricated as described above is placed on the wiring substrate on which the wiring having the same shape as that of the electrode of the solar cell is formed, as shown in Figs. 8 (a) to (c), and the properties of the fabricated solar battery are measured using the four-terminal method. The result is shown in Table 2.

**[Table 2]**

| Firing Temperature | Short Circuit Current Density Jsc (mA/cm²) | Open-circuit Voltage Voc (V) | F.F. | Conversion Efficiency Eff (%) |
|---|---|---|---|---|
| 650°C | 36.44 | 0.639 | 0.775 | 18.05 |
| 450°C | 37.12 | 0.647 | 0.771 | 18.53 |

Here, copper foil is used for the wiring of the wiring substrate and the wiring is designed to have a sufficiently low resistance. Therefore, by placing the solar cell on the wiring substrate, the resistance of the electrode of the solar cell is negligible.

Accordingly, by placing on the wiring substrate the solar cell having high resistivity p of the electrode formed by firing the electrode paste at 450°C as shown in Table 1, the resistance loss produced by the electrode is eliminated and the F.F. is significantly improved to 0.771 as shown in Table 2.

In addition, as shown in Table 2, even when the solar cell having low resistivity p of the electrode formed by firing the electrode paste at 650°C is used, an improvement in F.F. is confirmed and it is seen that the resistance of the electrode does not become sufficiently low even in firing at 650°C.

As described above, even when the resistance of the electrode is high in firing at 450°C, the use of the wiring substrate allows high F.F. to be obtained if the contact resistance with the silicon substrate is low. The solar cell used in the above has an approximately 10 cm square size. When the solar cell further becomes larger, it is anticipated that, with a method for collecting electricity at the opposing ends of the solar cell, an influence of the resistance of the electrode will become larger and the F.F. will be significantly reduced even in firing at 650°C. Even in this case, however, with the above method in which the wiring substrate is used, the problems can be readily handled by thickening the wiring of the wiring substrate, for example, the copper foil. On the other hand, with the method for increasing the thickness of the electrode as in the prior art, it is technically difficult to form the thick electrode by screen printing, and the large amount of the expensive electrode paste such as silver paste is used, which leads to very high material cost.

In addition, when a current generated at the solar cell is collected at the wiring substrate via the electrode of the solar cell as in the above method, the loss due to the resistance of the electrode tends to be produced if the electrode of the solar cell is thick as in the prior art. Therefore, the electrode of the solar cell should be as thin as possible. When the insulating passivation film is formed on the back surface of the solar cell, however, the thickness of the electrode of the solar cell is preferably equal to or larger than the thickness of the passivation film in order that the electrode of the solar cell is reliably connected to the wiring of the wiring substrate.

Moreover, the electrode of the solar cell should be preferably as thin as possible. The electrode of the solar cell preferably has a thickness of 20 µm or less because the effect of improvement in F.F. produced by the wiring substrate is obtained even when the electrode of the solar cell has a thickness of 20 µm as described above.

Furthermore, the short circuit current density and the open-circuit voltage of the solar battery when the electrode is formed by firing the electrode paste at 450°C is higher than those when the electrode is formed by firing the electrode paste at 650°C. This is because a reduction in carrier lifetime in the silicon substrate can be prevented as a result of decreasing the firing temperature of the electrode paste. Consequently, the solar battery having higher conversion efficiency is obtained when the electrode paste is fired at 450°C than when the electrode paste is fired at 650°C.

The conventional electrode of the solar battery has played two roles of extraction and collection of a current from the silicon substrate. Therefore, when the firing temperature of the electrode paste was decreased with the aim of improving the short circuit current density and the open-circuit voltage as described above, the resistance of the electrode became high, which resulted in a reduction in conversion efficiency of the solar battery.

In the present invention, however, the electrode of the solar cell extracts a current from the silicon substrate, and the wiring substrate on which the wiring is designed to have a sufficiently low wiring resistance collects the extracted current. Therefore, the solar battery having an F.F. of 0.75 or more is obtained regardless of the resistance of the electrode when the contact resistance between the electrode of the solar cell and the silicon substrate is 70 mΩ·cm² or less, and more preferably 50 mΩ·cm² or less. Consequently, the solar battery and the solar cell module having high conversion efficiency are obtained.

In addition, in the present invention, the electrode of the solar cell may only achieve excellent contact with the silicon substrate. Therefore, formation of the thick electrode is not required unlike in the prior art (since the electrode is a resistance component, the electrode should be preferably as thin as possible), and the amount of the electrode material used can be significantly reduced, which allows reduction in material cost.

Furthermore, in the present invention, since printing of the thick electrode paste is not required, various printing methods such as ink-jet printing, offset printing, relief printing, and intaglio printing can be used in addition to screen printing that has been a common method for printing the electrode paste. Therefore, formation of the electrode having a higher-definition pattern is also possible.

### (Second Embodiment)

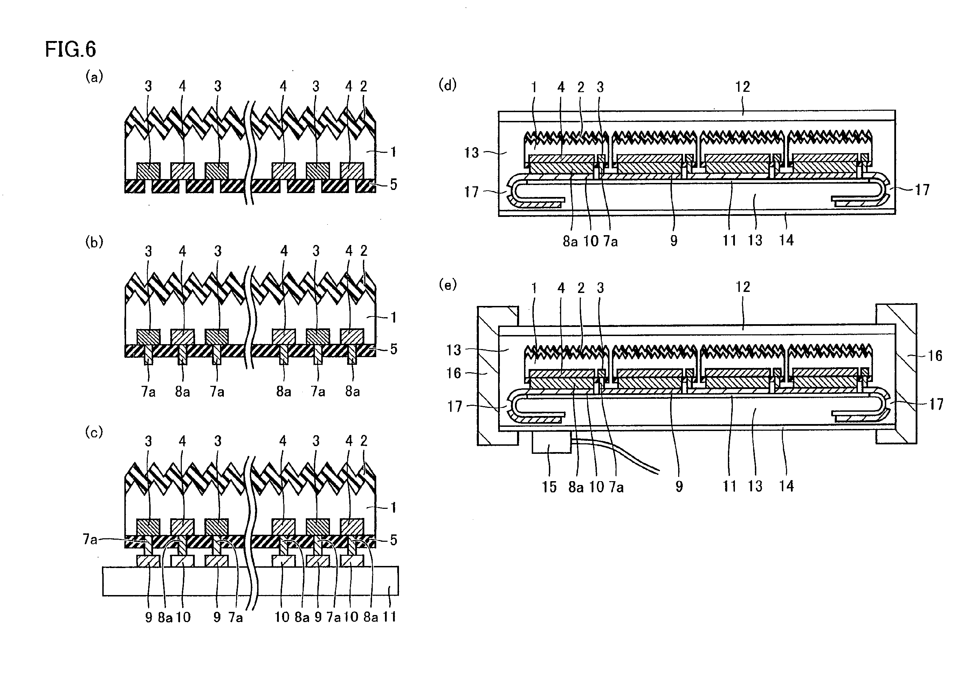

Another example of the method for manufacturing the solar cell module of the present invention will be described hereinafter with reference to schematic cross-sectional views in Figs. 6 (a) to (e).

First, as shown in Fig. 6 (a), p+ layer 3 formed by diffusing p-type impurities and n+ layer 4 formed by diffusing n-type impurities are formed on a back surface of a p-type silicon substrate 1, for example. In addition, passivation film 5 having the contact hole that is the opening formed to expose a part of the surface of p+ layer 3 and a part of the surface of n+ layer 4 is formed on the back surface of silicon substrate 1. Furthermore, antireflection film 2 is formed on a light receiving surface of silicon substrate 1. Here, above antireflection film 2, p+ layer 3, n+ layer 4, and passivation film 5 can be formed by using a conventionally known method, respectively.

In addition, although each of p+ layer 3 and n+ layer 4 is alternately arranged in the shape of a line linearly extending from the front side to the rear side of the sheet of Fig. 6 (a) in this example as well, p+ layer 3 and n+ layer 4 are not limited to this configuration.

Furthermore, the contact hole provided with passivation film 5 can be formed on each of p+ layer 3 and n+ layer 4 in the shape of, for example, a dot, a line or the like. The contact hole can be easily formed by, for example, printing a paste, which can etch passivation film 5, on passivation film 5 in the shape of the contact hole and heating the paste.

Next, as shown in Fig. 6 (b), a p electrode 7a and an n electrode 8a of the solar cell are formed on the contact hole of passivation film 5 by electrolytic plating, electroless plating or vacuum deposition. Here, the electrode (p electrode 7a and n electrode 8a) preferably includes Ag, Ni, Cu, or Al as a main ingredient.

Conventionally, electrolytic plating, electroless plating or vacuum deposition has not been used as a method for forming the electrode of the solar cell. One of the reasons for this is that the growth speed of the electrode is slow and it takes time to form the electrode.

In the present invention, however, formation of the thick electrode of the solar cell is not required. As long as excellent contact with the silicon substrate is obtained, the electrode of the solar cell should be advantageously as thin as possible. Therefore, the electrode can be formed by electrolytic plating, electroless plating or vacuum deposition.

In other words, in the conventional electrode of the solar cell, the resistance of the electrode has needed to be suppressed to be low, and thus, a thickness of approximately tens of micrometers has been required. When the electrode having such thickness is formed by electrolytic plating, electroless plating and vacuum deposition, the formation speed of the electrode is approximately several nanometers to several micrometers per minute. Therefore, it takes at least 10 minutes or more.

On the other hand, in the present invention, the electrode of the solar cell should be preferably as thin as possible. For example, the thickness of the electrode of the solar cell can be reduced to 1 µm or less. Therefore, the formation time of the electrode of the solar cell can be shortened to several minutes or less. In addition, the amount of the electrode material used can also be reduced. In this case as well, however, in order to obtain excellent connection to the wiring of the wiring substrate, the thickness of the electrode of the solar cell is preferably equal to or larger than the thickness of the passivation film (insulating film) when the passivation film (insulating film) is formed on the back surface of the solar cell.

In particular, the formation speed of the electrode by electroless plating is slower than the formation speed of the electrode by electrolytic plating. In electroless plating, however, p electrode 7a and n electrode 8a can be formed simply by immersing the silicon substrate in a plating solution, and electroless plating does not include a vacuum process unlike vacuum deposition. Therefore, electroless plating is preferable in that formation of the electrode is easy.

Here, electroless plating can be performed by using, for example, a conventionally known method. For example, by heating the plating solution including Ni as a main ingredient to approximately 80°C and immersing the silicon substrate having the contact hole as shown in Fig. 6 (a) formed in the plating solution for about three minutes, p electrode 7a and n electrode 8a formed of an Ni layer and having a thickness of approximately 0.3 µm can be formed on the exposed portion of the silicon substrate as shown in Fig. 6 (b). The passivation film on the back surface of the solar cell has already been formed to have a thickness of 0.1 µm. In addition, a catalytic treatment may be provided before the silicon substrate is immersed in the plating solution in order to promote growth of the electrode.

In order to improve contact with the silicon substrate, annealing is preferably performed at a temperature of, for example, approximately 300 to 500°C after the electrode of the solar cell is formed according to the above method. Although the atmosphere for annealing is not particularly limited, the atmosphere of a mixed gas of hydrogen and nitrogen, for example, can be used. By forming the electrode of the solar cell as described above, the electrode having a contact resistance with the silicon substrate of 70 mΩ•cm² or less, and preferably 50 mΩ•cm² or less, can be achieved.

Next, as shown in Fig. 6 (c), the solar cell is placed on the wiring substrate including p wiring 9 and n wiring 10 that correspond to p electrode 7a and n electrode 8a of the solar cell, respectively, such that p electrode 7a is placed on p wiring 9 and n electrode 8a is placed on n wiring 10. As a result, the solar battery of the present invention is fabricated.

Here, electrical connection between p electrode 7a and p wiring 9 as well as electrical connection between n electrode 8a and n wiring 10 may be achieved by, for example, a connection material such as solder or a conductive adhesive, or may be achieved only by physical press-bonding using vacuum press-bonding in a subsequent sealing step with a sealant without using this connection material.

In addition, in the present invention, the electrode of the solar cell may only achieve excellent contact with the wiring of the wiring substrate, and thus, the electrode of the solar cell should be as small in surface area as possible in such a range that the properties of the solar battery are not affected, for the purpose of reducing the amount of the electrode material used.

On the other hand, the wiring of the wiring substrate should be as large in surface area as possible for the purpose of sufficiently reducing the serial resistance to collect a current collected from the solar cell. Accordingly, as shown in, for example, the schematic cross-sectional view in Fig. 4, width D1 of the wiring of the wiring substrate is preferably larger than width D2 of the electrode of the solar cell.

Next, as shown in Fig. 6 (d), the solar cell placed on the wiring substrate is sealed with translucent sealant 13, translucent member 12 such as glass, and weather-resistant base material 14.

Finally, as shown in Fig. 6 (e), terminal box 15 and frame 16 are attached. As a result, the solar cell module of the present invention is completed. By fabricating the solar cell module as described above, the solar cell module of the present invention having an F.F. of 0.75 or more can be achieved.

As described above, according to the present invention, since the wiring substrate serves the function of collecting electricity, the electrode of the solar cell may only achieve excellent contact with the silicon substrate. Therefore, the material cost can be reduced, the properties of the solar battery can be enhanced, and the manufacturing time can be shortened.

It should be understood that the embodiments and the examples disclosed herein are illustrative and not limitative in any respect. The scope of the present invention is defined by the terms of the claims, rather than the above description, and is intended to include any modifications within the scope and meaning equivalent to the terms of the claims. For example, although the wiring of the wiring substrate is shaped to cover the overall electrode of the solar cell in the present examples, there may be a portion where the wiring of the wiring substrate is not partially in contact with the electrode of the solar cell, that is, for example, the tip of the electrode of the solar cell may be longer than the wiring of the wiring substrate, in such a range that the F.F. is not reduced.

### INDUSTRIAL APPLICABILITY

According to the present invention, there can be provided a solar battery capable of suppressing the resistance of an electrode to be low and enhancing properties, a method for manufacturing the solar battery and a solar cell module.

## Claims

1. A solar battery, comprising:
a solar cell including an electrode (7, 8) having a contact resistance with a silicon substrate (1) of 70 mΩ•cm² or less; and
a conductive member for electrically connecting to said electrode (7, 7a, 8, 8a) of said solar cell,
said solar cell being arranged on said conductive member such that said electrode (7, 7a, 8, 8a) of said solar cell is electrically connected to said conductive member.

2. The solar battery according to claim 1, wherein
said electrode (7, 7a, 8, 8a) includes Ag, Ni, Cu, or Al as a main ingredient..

3. The solar battery according to claim 1, wherein
said electrode (7, 7a, 8, 8a) has a thickness of 20 µm or less.

4. The solar battery according to claim 1, wherein
a pattern of formation of said electrode (7, 7a, 8, 8a) substantially overlies a pattern of formation of said conductive member when the pattern of formation of said electrode (7, 7a, 8, 8a) is electrically connected to the pattern of formation of said conductive member.

5. The solar battery according to claim 1, wherein
said conductive member is a wiring substrate including an insulating base material (11) and a wiring (9, 10) placed on said insulating base material (11).

6. The solar battery according to claim 5, wherein
said wiring (9, 10) includes Ag, Ni, Cu, or Al as a main ingredient.

7. The solar battery according to claim 5, wherein
a width of said electrode (7, 7a, 8, 8a) is smaller than a width of said wiring (9, 10) of said wiring substrate.

8. The solar battery according to claim 1, wherein
in said solar cell, a p electrode (7, 7a) and an n electrode (8, 8a) are both formed on a back surface side of said silicon substrate (1).

9. The solar battery according to claim 1, wherein
said electrode (7, 7a, 8, 8a) is a fired electrode.

10. A method for manufacturing the solar battery as recited in claim 1, said electrode (7, 7a, 8, 8a) being formed by printing an electrode paste including metallic powder as a main ingredient, and then, firing said electrode paste.

11. The method for manufacturing the solar battery according to claim 10,
wherein
said electrode paste contains said metallic powder, a solvent, a thickener, and a glass frit having a softening point of 450°C or less.

12. The method for manufacturing the solar battery according to claim 10,
wherein
said electrode paste is fired at a temperature of 550°C or less.

13. A method for manufacturing the solar battery as recited in claim 1, said electrode (7, 7a, 8, 8a) being formed by electrolytic plating, electroless plating or vacuum deposition.

14. A solar cell module, formed by sealing the solar battery as recited in claim 1 with a sealant.
